# EUROPÄISCHE PATENTSCHRIFT

(11) **EP 0 805 480 B1**
(45) Veröffentlichungstag und Bekanntmachung des Hinweises auf die Patenterteilung: **13.03.2002**
(21) Anmeldenummer: 97111117.4
(22) Anmeldetag: 17.12.1992
(51) Int. Cl.: H01L 21/00

(54) **SMIF-System zum Einschleusen von Substraten in Schleusenreinsträume**
SMIF device for introduction of substrates into clean transfer rooms
Système SMIF pour introduire des substrats dans des pièces de transfert purifiées

(30) Priorität: 09.03.1992 DE 4207341
(43) Veröffentlichungstag der Anmeldung: 05.11.1997
(62) Teilanmeldung aus: 93901038.5
(73) Patentinhaber: GENTISCHER, Josef, 73630 Remshalden (DE)
(72) Erfinder: GENTISCHER, Josef, 73630 Remshalden (DE)
(74) Vertreter: Dreiss, Fuhlendorf, Steimle & Becker

(56) Entgegenhaltungen:
- EP-A- 0 340 345
- US-A- 5 207 578

## Beschreibung

Die Erfindung betrifft ein SMIF-System zum Einschleusen von Substraten in einen Schleusenreinstraum gemäß dem Anspruch 1.

Ein System - das mit dem Fachbegriff "Standard Mechanical Interface (SMIF)" bezeichnet wird - ist aus der US-PS 4,995,430 bekannt. Der gravierende Nachteil dieses Systems ist, daß der Verriegelungsmechanismus einerseits und der Arretiermechanismus andererseits voneinander völlig getrennt ausgeführt sind. Dies bringt in nachteiliger Art und Weise mit sich, daß eine komplexe Überwachungs- und Steuerelektronik vorgesehen werden muß, welche gewährleisten soll, daß einerseits die Verriegelung des Boxenbodens in der Box erst dann gelöst wird, wenn die Box im Aufnahmerahmen arretiert ist und daß andererseits der Boxenboden in der Box verriegelt wird, bevor die Arretierung der Box im Aufnahmerahmen aufgehoben wird.

Ein weiterer Nachteil des bekannten Systems besteht darin, daß bei diesem die Antriebsvorrichtung zum Ver- und Entriegeln des Boxenbodens in der Box mittels der normgemäß hierfür vorgesehenen Drehscheibe unterhalb des Schleusentors angeordnet ist. Dies bringt in nachteiliger Art und Weise mit sich, daß das bekannte System nicht in Reinstraum-Anlagen integriert werden kann. Vielmehr muß das SMIF an die Reinstraum-Anlage angedockt werden. Zur Absenkung des Schleusentors ist dann ein separates Hubwerk erforderlich. Außerdem wird eine separate Transportvorrichtung benötigt, welche die Substrat-Kassette des bekannten Systems vom abgesenkten Schleusentor zu einem Hubwerk der Reinstraum-Anlage transportiert, von der aus dann die weitere Handhabung der Kassette mit den darin aufgenommenen Substraten stattfindet. Das bei den bekannten SMIF-Systemen erforderliche separate Hubwerk und die die Substrat-Kassette vom Hubwerk des SMIF's zum Hubwerk der Reinstraum-Anlage bewegende Transportvorrichtung verteuert und verkompliziert nachteiligerweise den Aufbau des bekannten SMIF-Systems.

Ein weiterer Nachteil liegt im komplizierten Aufbau des Verriegelungsmechanismus. Um die Kippbewegung der Verriegelungselemente am Ende des Verriegelungsvorganges des Boxenbodens in der Box zu erreichen, ist vorgesehen, daß die die Schubstangen an der Schwenkscheibe anlenkenden Bolzen in einem Nockengang der Schwenkscheibe geführt werden, womit durch eine Erhöhung des Anlenkpunktes der Schubstangen eine kippbewegung der Verriegelungselemente erreicht wird. Eine derartige konstruktive Lösung ist nicht nur kompliziert und daher teuer in der Herstellung der Schwenkscheibe samt Nockengängen. Sie erhöht auch in nachteiliger Art und Weise die erforderliche Bauhöhe des Boxenbodens. Außerdem bringt eine derartige Konstruktion aufgrund der beim Abkippen der Verriegelungselemente auftretenden erhöhten Materialbelastung der Bolzen und des Nockengangs einen übermäßigen Verschleiß dieser Teile mit sich.

Ein weiterer Nachteil der bekannten Systeme liegt in ihrer fehlenden oder unzureichenden Berücksichtigung der lufttechnischen Belange, die bei Reinstraum-Anlagen zur Verhinderung einer Kontamination der äußerst empfindlichen Substrate erforderlich sind. Es sind bei den bekannten Systemen keine oder nur ineffiziente Einrichtungen vorgesehen, die eventuell in den Reinstraum eingedrungene Schwebstoffe von den Substraten fernhalten. Dieser Nachteil der bekannten Systeme wirkt sich hierbei besonders gravierend aus, da das im Reinstraum angeordnete und das Schleusentor absenkende Hubwerk selbst derartige Schwebstoffe in den Reinstraum einbringt: An den reibungsbehafteten Stellen des Hubwerks entstehen nämlich Abriebpartikel, welche bei den bekannten Systemen in nachteiliger Art und Weise in den die Substrate aufnehmenden Teil des Reinstraumes gelangen.

Aus der WO 86/00870 ist ein System zum Einschleusen von Substraten in einen Reinstraum bekannt, das eine Einrichtung aufweist, die es erlaubt, den Boxenboden der die Substrate aufnehmenden Box am Schleusentor zu arretieren. Dies wird dadurch bewirkt, daß eine mit einem Federnpaar zusammenwirkende elektrische Spule vorgesehen ist, deren Aktivierung bewirkt, daß die Federn des Federnpaars die Verriegelung des Boxenbodens und der zugehörigen Box lösen und gleichzeitig den Boxenboden am Schleusentor arretieren.

Aus der Zeitschrift "Solid State Technology 33 (1990) August, No. 8: Wafer Confinement for Control of Contamination in Microelectronics" ist es bekannt, bei einem System zum Einschleusen von Substraten in Reinsträume, also bei einem SMIF-System, den unter dem Schleusentor des Reinstraums liegenden Bereich mit Druckluft zu beaufschlagen, um damit eine Kontamination der Substrate zu verhindern. In der o.g. Druckschrift ist die Druckluftströmung nicht näher und detaillierter beschrieben. Inbesondere ist nicht offenbart, wie in dem zu spülenden Bereich des Reinstraums eine laminare Verdrängungsströmung ausgebildet werden kann.

Aus der EP-A-340 345 ist eine Vorrichtung zum Ein- und Ausschleusen von Substraten aus einem Vakuumkessel bekannt, bei dem die die Substrate aufnehmende Kassette in einen bis auf eine Luft-Abführöffnung geschlossenen Unterkasten eingesetzt wird. In diesen einen geschlossenen Käfig ausbildenden Unterkasten wird durch dessen perforierte Wände über einen Druckluftanschluß Reinstluft zugeführt, welche von einer externen Luftaufbereitungseinheit erzeugt und unter Druck zum Unterschrank geleitet wird.

Bei der bekannten Vorrichtung ist die gesamte Bewegungsmechanik in dem unter dem Schleusentor gelegenen Raum nicht gegenüber den Substraten abgeschirmt.Durch unvermeidbare Strömungsablösungen bzw. Verwirbelungen infolge der Druckluftbeaufschlagung kann eine Vermischung der Luftströmung mit Abriebpartikeln auftreten, welche die Gefahr einer Kontamination der Substrate mit sich bringt.

Der Erfindung gemäß dem Anspruch 1 stellt sich nun die Aufgabe, ein SMIF-System der eingangs genannten Art derart weiterzubilden, dass die oben beschriebenen Nachteile vermieden werden.

Zur Lösung dieser Aufgabe sind die im Anspruch 1 angegebenen Merkmale vorgesehen.

Durch die erfindungsgemäßen Maßnahmen ist erreicht, dass in vorteilhafter Art und Weise den lufttechnischen Belangen einer derartigen Schleusenreinstraumanlage Rechnung getragen wird. Der zugeführte Reinstluftstrom bewirkt eine Spülung der Substrate. Außerdem verhindert die durch den Reinstluftstrom hervorgerufene Verdrängungsströmung einen Zufluß von kontaminierter Luft zu den äußerst empfindlichen Substraten, so dass eine Verunreinigung derselben durch eventuell im Reinstraum vorhandene Schwebeteilchen verhindert wird. Durch die erfindungsgemäße Anordnung der Lüftungseinrichtung, die im Reinstraum integriert und abluftseitig angeordnet ist, ist es erst möglich, bei einem SMIF-System die zur einwandfreien Spülung der Substrate erforderliche Strömungsrichtung zu erreichen. Da das Druckgefälle zwischen der Einströmöffnung des Schleusenreinstraums und der Abluftöffnung durch die im Schleusenreinstraum integrierte Lüftungseinrichtung in diesem selbst erzeugt wird, sind die Substrate an der Saugseite der Lüftungseinrichtung und nicht an deren Druckseite angeordnet. Daraus ergeben sich vorteilhafte strömungstechnische Eigenschaften des Reinstluftstromes.

Vorzugsweise wird hierbei die Richtung des Reinstluftstroms parallel zur Oberfläche der zuströmenden Substrate gewählt, so daß ein turbulenzfreier Verlauf des Reinstluftstroms im Reinstraum gewährleistet ist.

Eine vorteilhafte Weiterbildung der Erfindung sieht vor, daß im Reinstraum ein Gitterelement vorgesehen ist, das in besonders vorteilhafter Art und Weise eine Verstetigung des den Reinstraum durchströmenden Reinstluftstroms bewirkt. Dieses Gitterelement kann hierbei - in Strömungsrichtung des Reinstluftstroms gesehen - vor einem im Reinstraum integrierten Hubwerk angeordnet. Durch diese erfindungsgemäße Anordnung wird in vorteilhafter Art und Weise erreicht, daß das Gitterelement außer seinen luftleittechnischen Aufgaben auch noch eine mechanische Abschirmung des das Hubwerk aufnehmenden Teils des Reinstraums zukommt, so daß bei der Hubewegung des Hubwerks erzeugte Abriebpartikel in vorteilhafter Art und Weise nicht unmittelbar in den die Substrate aufnehmenden Teil des Reinstraums gelangen können.

Eine weitere vorteilhafte Weiterbildung der Erfindung sieht vor, daß der Reinstluftstrom nach dem Durchströmen des die Substrate aufnehmenden Teils des Reinstraums zu dem im Reinstraum integrierten Hubwerk geleitet wird. Durch die erfindungsgemäß vorgesehene Flutung des Hubwerks mit dem Reinstluftstrom werden Abriebpartikel, die an den reibungsbehafteten Teilen des Hubwerks entstehen, von dem die Substrate aufnehmenden Teile des Reinstraums ferngehalten und in vorteilhafter Art und Weise vom Reinstluftstrom abtransportiert und somit aus dem Reinstraum entfernt. Durch diese Maßnahme wird in vorteilhafter Art und Weise eine deutliche Erhöhung der lufttechnischen Belange einer derartigen Reinstraum-Anlage erreicht.

Vorteilhafte Weiterbildungen ergeben sich aus den Unteransprüchen.

Weitere Einzelheiten der Erfindung sind dem Ausführungsbeispiel zu entnehmen, welches nachstehend anhand der Figuren beschrieben wird. Es zeigen:
- Figur 1: einen Schnitt durch ein erstes Ausführungsbeispiel,
- Figur 2: eine Explosionsdarstellung der Fig. 1,
- Figur 3: einen Schnitt durch einen Boxenboden des ersten Ausführungsbeispiels,
- Figur 4: einen Schnitt durch den Boxenboden entlang der Linie IV-IV der Fig. 2,
- Figur 5: einen Schnitt durch einen Aufnahmerahmen des ersten Ausführungsbeispiels,
- Figur 6: eine Draufsicht auf den Aufnahmerahmen aus der Richtung VI der Fig. 2,
- Figur 7 und 8: Teile der Arretiervorrichtung des Ausführungsbeispiels,
- Figur 9: eine Unteransicht eines Schleusentors ohne Bodenplatte des ersten Ausführungsbeispiels,
- Figur 10 und 11: einen Schnitt durch ein zweites Ausführungsbeispiel,
- Figur 12: einen Schnitt durch das zweite Ausführungsbeispiel entlang der Linie XII-XII der Fig. 10,
- Figur 13: einen Schnitt durch einen Boxenboden des zweiten Ausführungsbeispiels,
- Figur 14: einen Schnitt durch den Boxenboden entlang der Linie XIV-XIV der Fig. 13,
- Figur 15: die Einzelheit Y der Fig. 10 ohne Kassette, in vergrößertem Maßstab und entsprechend einem Schnitt entlang XV-XV der Fig. 14,
- Figur 16: eine Unteransicht eines Schleusentors ohne Bodenplatte des zweiten Ausführungsbeispiels,
- Figur 17: einen Schnitt durch die Einzelheit X der Fig. 16 entlang der Linie XVII-XVII dieser Figur in vergrößertem Maßstab.

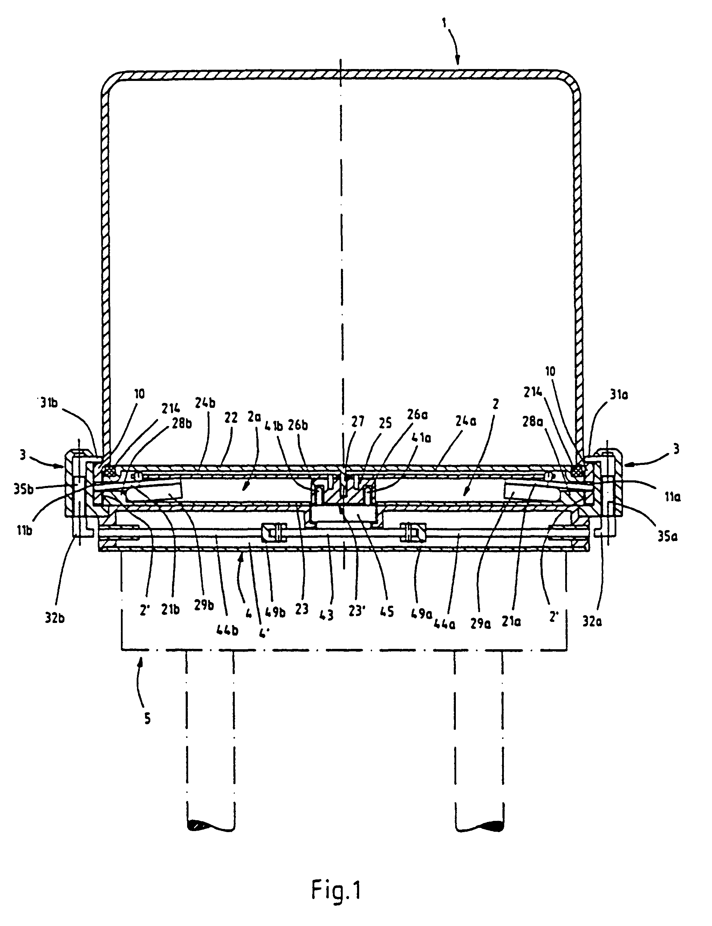

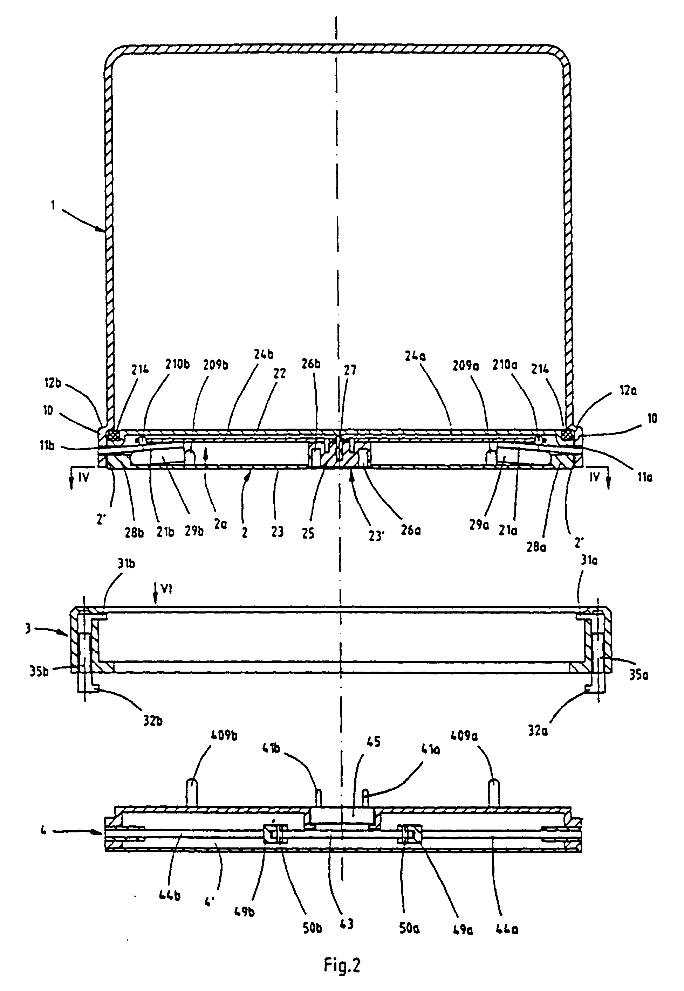

Das in den Figuren 1 und 2 dargestellte erste Ausführungsbeispiel eines Systems zum Einschleusen von Substraten in Reinsträume weist eine Box 1, einen Boxenboden 2, einen Aufnahmerahmen 3 und ein Schleusentor 4 auf. Der durch die Box 1 und den Boxenboden 2 umschlossene Raum dient in bekannter Art und Weise zur Aufnahme einer in Fig. 1 und 2 nicht dargestellten Kassette mit Substraten, welche in den nicht dargestellten, unterhalb des Schleusentors 4 gelegenen Reinstraum gebracht werden sollen.

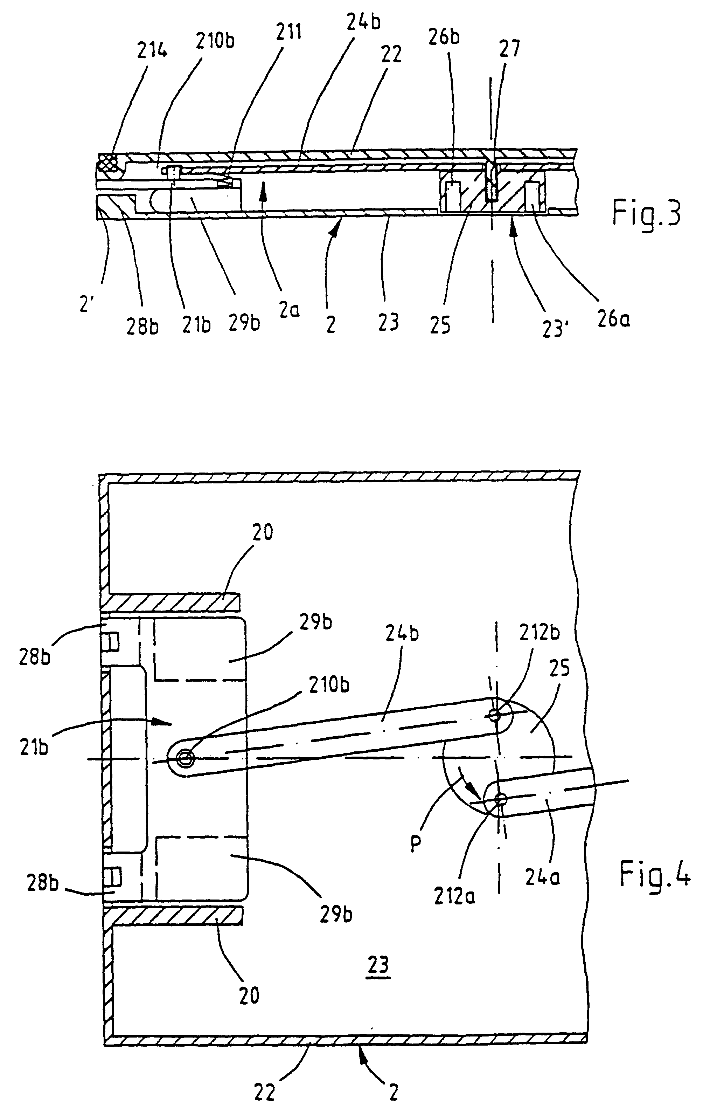

Die Box 1 weist in ihrem unteren, an den Seitenflächen 2' des Boxenbodens 2 anliegenden Bereich 10 zwei Verriegelungsschlitze 11a, 11b auf, in welche je ein Verriegelungselement 21a, 21b eines Verriegelungsmechanismus des Boxenbodens 2 eingreifen. Hierzu wird auch auf die Fig. 3 und 4 verwiesen, in denen jeweils nur die linke Hälfte des symmetrisch aufgebauten Verriegelungsmechanismus dargestellt ist. Der in einem durch ein Gehäuse 22 des Boxenbodens 2 umgrenzten Hohlraum 2a angeordnete Verriegelungsmechanismus weist eine Schwenkscheibe 25 auf, welche um einen Zapfen 27 des Gehäuses drehbar ist. An der Oberseite der Schwenkscheibe 25 ist (wie aus Fig. 4 ersichtlich ist) über je ein Gelenk 212a, 212b je ein Ende einer Schubstange 24a, 24b angelenkt, deren anderes Ende über je ein weiteres Gelenk 210a, 210b mit dem als Riegel ausgebildeten Verriegelungselement 21a, 21b verbunden ist. Jedes Verriegelungselement 21a bzw. 21b weist je zwei Kufen 29a bzw. 29b auf, die am hinteren, der Schwenkscheibe 25 zugeordneten Ende des Verriegelungselements 21a, 21b angeordnet sind und auf der Unterseite 23 des Gehäuses 22 des Boxenbodens 2 gleiten. In einer im hinteren Bereich des Verriegelungselements 21a, 21b angeordneten Vertiefung setzt je eine Druckfeder 211 an (s. Fig. 3), die sich auf der zugeordneten Schubstange 24a, 24b abstützt und verhindert, daß das Verriegelungselement 21a, 21b bei seiner durch die Drehbewegung der Schwenkscheibe 25 ausgelösten und durch die Schubstangen 24a, 24b übertragenen Verschiebebewegung auf der Unterseite 23 des Gehäuses 22 abkippt. Das Gehäuse 22 weist außerdem je zwei mit den Kufen 29a, 29b jedes Verriegelungselements 21a, 21b zusammenwirkende Anschläge 28a, 28b auf, welche die durch Führungselemente 20 (Fig. 4) des Gehäuses 22 geführte lineare Verschiebebewegung der Verriegelungselemente 21a, 21b in Richtung der Verriegelungsschlitze 11a, 11b begrenzen.

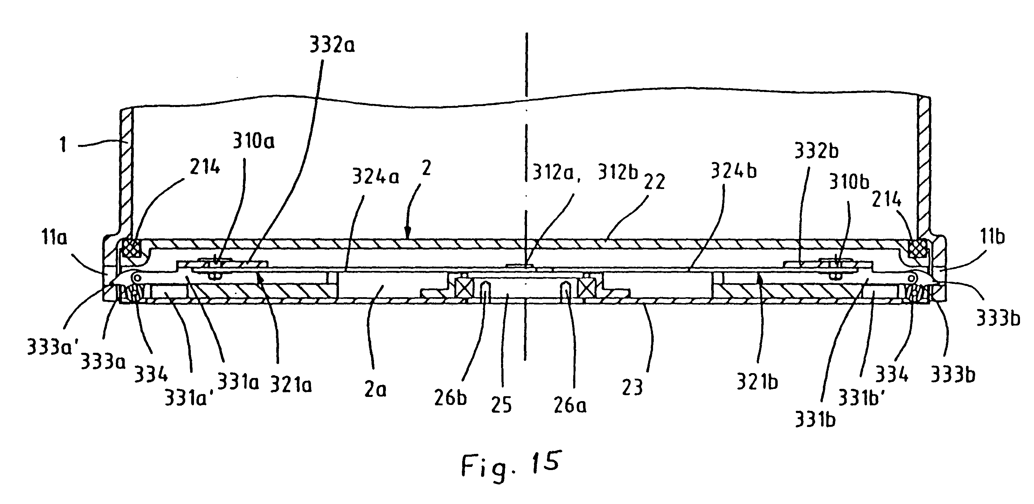

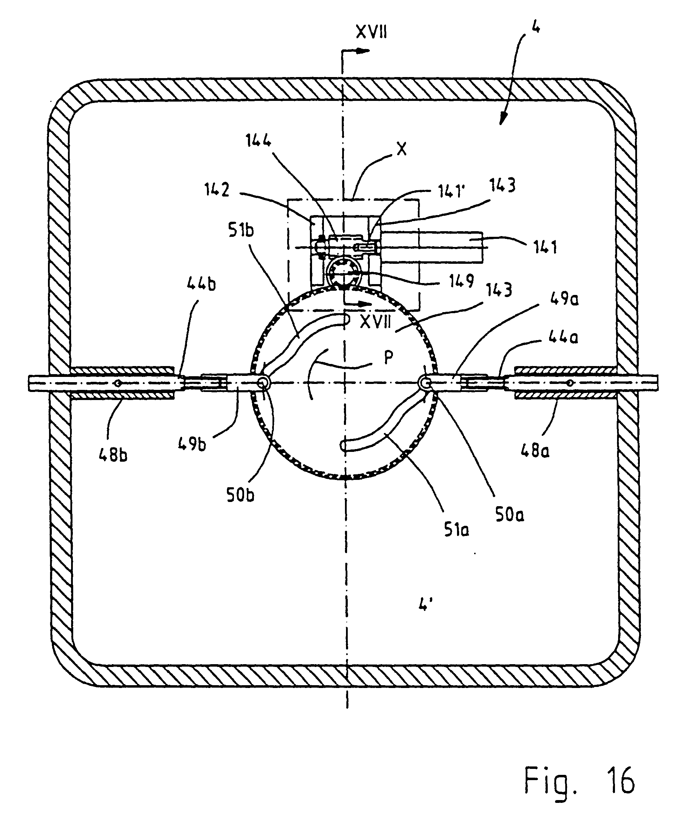

Die beschriebene Art des Antriebs der Verriegelungselemente 21a, 21b mittels der Schubstangen 24a, 24b ist nicht die einzig mögliche Konstruktionsweise. Dem Fachmann ist vielmehr aufgrund obiger Beschreibung leicht ersichtlich, welche Alternativen er einsetzen kann, um die Bewegung der Schwenkscheibe 25 in eine Ver- und Entriegelungsbewegung der Verriegelungselemente 21a, 21b umzusetzen. Beispielhafterweise wird hierzu auf die weiter unten folgende Beschreibung eines zweiten Ausführungsbeispiels und insbesondere auf die Fig. 15 und 16 verwiesen.

Die Verriegelung des Boxenbodens 2 in der Box 1 wird nun wie folgt durchgeführt: Wird die Schwenkscheibe 25 in Richtung des Pfeiles P geschwenkt, so bewegt die Schubstange 24a, 24b ihr zugeordnetes Verriegelungselement 21a, 21b nach außen. Dieses führt zunächst eine lineare Bewegung aus und greift dabei in die Verriegelungsschlitze 11a, 11b der Box 1 ein. Sobald die Kufen 29a bzw. 29b an die Anschläge 28a bzw. 28b stoßen, werden die Verriegelungselement 21a, 21b abgekippt. Dadurch wird eine Verspannung zwischen der Box 1 und einer entlang des gesamten Umfanges des Boxenbodens 2 laufenden Dichtung 214 hervorgerufen, wobei infolge des beim Abkippen der Verriegelungselemente 21a, 21b auftretenden Kniehebeleffekts der Schubstangen 24a, 24b in vorteilhafter Art und Weise eine besonders hohe Krafteinwirkung auf die Dichtung 214 des Boxenbodens 2 erreicht wird. Diese wird daher besonders fest gegen die Box 1 gedrückt. Durch diesen hermetischen Abschluß des von der Box 1 und des in ihr verriegelten Boxenbodens 2 abgegrenzten Raumes ist es gefahrlos möglich, die darin aufgenommene Kassette samt dem Substrat durch unreine Räume zu transportieren.

In besonders vorteilhafter Art und Weise ist vorgesehen, daß bei der Schwenkbewegung der Schwenkscheibe 25 die Schubstangen 24a, 24b über den Totpunkt der Gelenke 212a, 212b gefahren werden. Durch dieses Überschnappen erhält man eine Selbsthemmung des Verschlußmechanismus, so daß die Verriegelung des Boxenbodens 2 in der Box 1 sicher und zuverlässig gegen ein selbsttätiges Öffnen gesichert ist.

Die Unterseite 23 des Gehäuses 22 weist eine Öffnung 23' auf, so daß Verriegelungsbolzen 41a, 41b einer Drehscheibe 45 des unter dem Boxenbodens 2 angeordneten Schleusentors 4 in an der Unterseite der Schwenkscheibe 25 vorgesehene Eingriffsbohrung 26a, 26b eintauchen können. Außerdem sind in der Unterseite 23 des Gehäuses 22 des Boxenbodens 2 mehrere, vorzugsweise drei Registrierbohrungen 209a, 209b (s. Fig. 2), die mit zugeordneten Registriervorsprüngen 409a, 409b (s. Fig. 2) des Schleusentors 4 zusammenwirken und gemeinsam mit dem Aufnahmerahmen 3 für eine lagegenaue Ausrichtung des Boxenbodens 2 und der Box 1 sorgen.

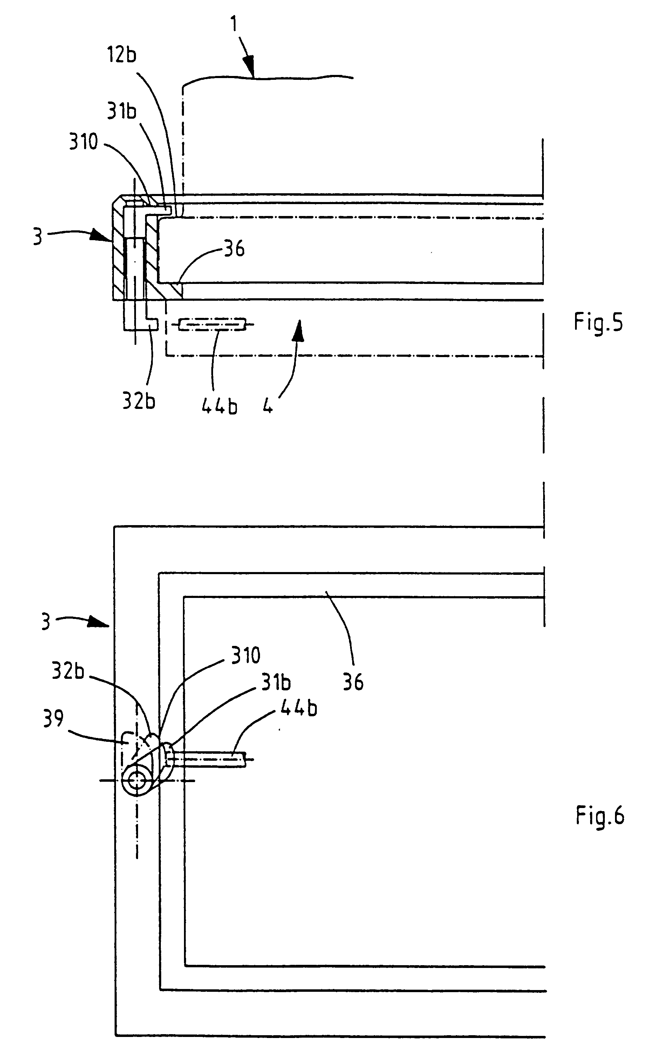

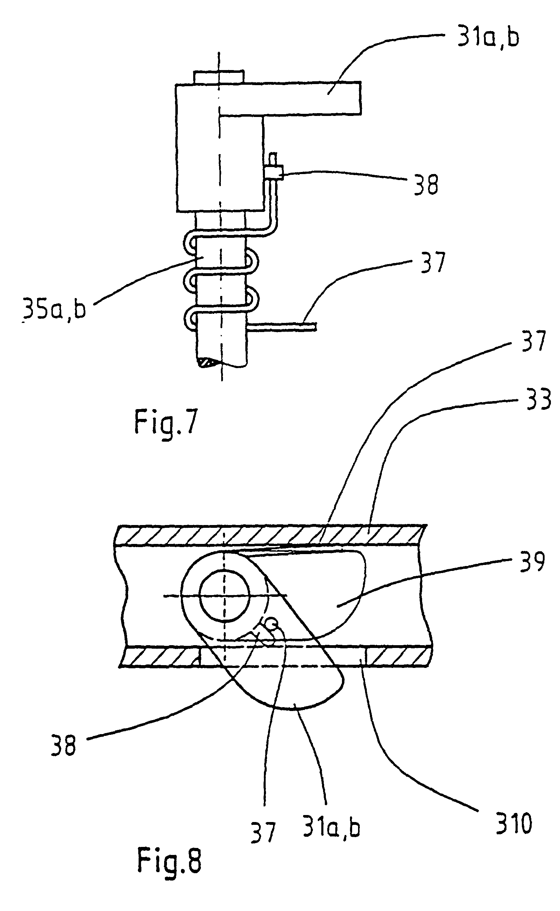

Zur Arretierung der Box 1 im Aufnahmerahmen 3 dienen Arretierelemente 31a bzw. 31b, welche an einer radial nach außen gerichteten Schulter 12a bzw. 12b der Box 1 (s. Fig. 2) angreifen. Die Arretierelemente 31a, 31b sind Bestandteile eines symmetrisch aufgebauten Arretiermechanismus, dessen linke Hälfte in den Fig. 5 bis 8 - auf die verwiesen wird - näher dargestellt sind. Im Aufnahmerahmen 3 sind zwei Ausfräsungen 39 (s. Fig. 6 und 8) angeordnet, die ein Zurückschwenken der Arretierelemente 31a, 31b aus der in den Fig. 1 und 2 dargestellten Arretiestellung in eine Aufnahmestellung erlauben, in der sie im Inneren des Aufnahmerahmens 3 positioniert sind und daher ein leichtes Einsetzen der Box 1 in den Aufnahmerahmen 3 ermöglichen. Jedes Arretierelement 31a, 31b ist - wie am besten aus Fig. 7 ersichtlich ist - auf einen Bolzen 35a, 35b aufgesetzt, welcher an seinem unteren Ende je einen Schwenkhebel 32a, 32b aufweist (Figuren 1, 2 und 5), der mit je einer aus dem Innenraum 4' des Schleusentors 4 hervortretenden weiteren Schubstange 44a, 44b zusammenwirkt. Eine Beaufschlagung der Schwenkhebel 32a, 32b durch die in Führungen 48a, 48b des Schleusentors 4 geführten weiteren Schubstangen 44a, 44b bewirkt, daß die Arretierelemente 31a, 31b entgegen der Federkraft je einer koaxial zum Bolzen 35a, 35b angeordnete Schwenkfeder 37 (Fig. 7) aus ihrer Arretierstellung, in der sie an den Schultern 12a, 12b der Box 1 angreifen und diese derart im Aufnahmerahmen (3) arretieren, durch Schlitze 310 des Aufnahmerahmens 3 hindurch in ihre Aufnahmestellung in Ausfräsungen 39 des Aufnahmerahmens 3 geschwenkt werden.

Hierbei ist vorgesehen, daß ein erstes Ende einer jeden Schwenkfeder 37 an einem radial nach innen verlaufenden Vorsprung 38 des Arretierelements 31a, 31b angreift, welcher gleichzeitig als Anschlag dient, der sich gegen das Gehäuse 33 des Aufnahmerahmens 3 abstützt und so den Schwenkwinkel der Arretierelemente 31a, 31b begrenzt (Fig. 8). Ein zweites Ende der Schwenkfeder stützt sich am Aufnahmerahmen 3 ab.

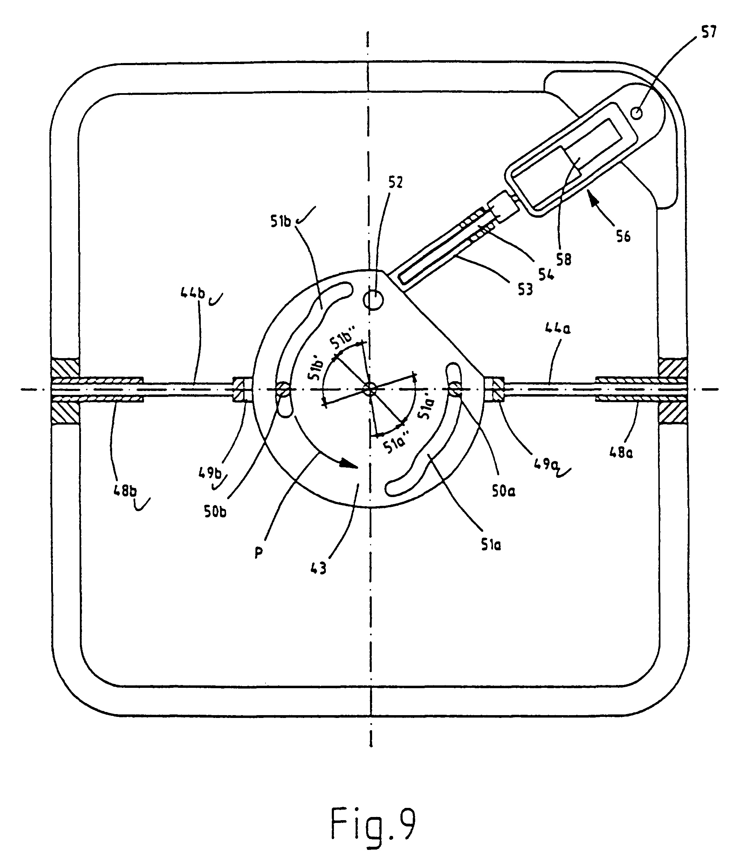

Die weiteren Schubstangen 44a, 44b sind - wie am besten aus den Fig. 1, 2 und 9 ersichtlich ist - an ihrem den Schwenkhebeln 32a, 32b abgewandten Ende mit je einer Gabel 49a, 49b versehen, die über je einen Führungsbolzen 50a, 50b in Schaltkurven 51a, 51b einer mit der Drehscheibe 45 fest verbundenen Kurvenscheibe 43 eingreifen. Hierzu wird auf die Figuren 2 bzw. 9 verwiesen. Die Schaltkurven 51a, 51b der Kurvenscheibe 43 sind dabei derart ausgebildet, daß sie in einem ersten Bereich 51a', 51b' einen konstanten Radius aufweisen. Dieser Radius ist dabei derart bemessen, daß die weiteren Schubstangen 44a, 44b die Schwenkhebel 32a, 32b nicht beaufschlagen oder - vorzugsweise - in den Innenraum 4' des Schleusentors 4 zurückgewichen sind, wenn sich die Bolzen 50a, 50b im ersten Bereich 51a', 51b' der Schaltkurven 51a, 51b der Kurvenscheibe 43 bewegen.

In einem an diesen ersten Bereich 51a', 51b' anschließenden zweiten Bereich 51a", 51b" vergrößert sich der Radius der Schaltkurven 51a, 51b, so daß bei einer weiteren Schwenkbewegung der Kurvenscheibe 43 in Richtung des Pfeiles P die über die Führungsbolzen 50a, 50b mit der Kurvenscheibe 43 verbundenen weiteren Schaltstangen 44a, 44b sich radial nach außen verschieben und die Schwenkhebel 32a, 32b beaufschlagen. Diese dadurch ausgelöste Schwenkbewegung der Schwenkhebel 32a, 32b überträgt sich über den Bolzen 35a, 35b auf die Arretierelemente 31a, 31b, wodurch diese von den Schultern 12a, 12b der Box 1 in die Ausfräsungen 39a, 39b des Aufnahmerahmens 3 zurückweichen und derart die Box 1 freigeben.

Diese Schwenkbewegung der Kurvenscheibe 43 wird durch die in Fig. 9 dargestellte Antriebsvorrichtung bewirkt, welche in besonders vorteilhafter Art und Weise im Innenraum 4' des Schleusentors 4 angeordnet ist. Diese Maßnahme bringt mit sich, daß das Hubwerk 5 (Fig. 1) des Reinstraumes direkt am Schleusentor 4 ansetzen kann. Somit wird es möglich, das beschriebene Schleusensystem als integralen Bestandteil des Reinstraumes auszubilden. Man ist daher nicht mehr - wie bei den bekannten Systemen darauf angewiesen, dieses an den Reinstraum anzudocken und eine separate Hubvorrichtung zum Absenken des Schleusentors 4 mit samt des Boxenbodens 2 vorzusehen. Denn es ist keine außerhalb des Schleusentors 4 angeordnete und daher störende Antriebsvorrichtung für den Arretiermechanismus mehr erforderlich.

Die gemeinsame Antriebsvorrichtung für den Arretier- und den Verriegelungsmechanismus weist einen Bügel 56 auf, der in einem Drehpunkt 57 gelenkig gelagert ist. Im Bügel 56 ist ein Motor 58 mit angesetztem Getriebe aufgenommen. Auf die Motorwelle des Motors 58 ist eine Gewindespindel 54 angeflanscht, die in ein Gegengewinde einer Gabel 53 eingreift. Die Gabel 53 lenkt über einen zweiten Anlenkpunkt 52 die Kurvenscheibe 43 an.

Abschließend zum konstruktiven Aufbau des beschriebenen Systems ist anzuführen, daß die Dimensionierung und die speziellen Abmessungen dieses "Standard Mechanical Interface's" im Dokument Nr. 1872 der SEMI-Norm (Semiconductor Equipment and Materials International) angegeben sind. Auf dieses Dokument wird somit explizit Bezug genommen. Die darin nicht enthaltenen Maßangaben ergeben sich für den Fachmann zwangsläufig aus obiger Beschreibung, so daß auf eine explizite Auflistung an dieser Stelle verzichtet werden kann.

Der Funktionsablauf beim Einschleusen einer in der Box 1 hermetisch abgedichtet aufgenommenen, mit Substrat befüllten Kassette verläuft nun wie folgt:

Im Verschlußzustand des Systems zum Einschleusen von Substraten in Reinsträume wird das Schleusentor 4 vom Hubwerk 5 der Reinstraum-Anlage fest gegen den Abdeckrahmen 36 des Aufnahmerahmens 3 gepreßt, so daß der unter dem Schleusentor 4 befindliche Reinstraum hermetisch abgeschlossen ist. Die weiteren Schubstangen 44a, 44b des Schleusentors 4 sind ausgefahren und beaufschlagen die Schwenkhebel 32a, 32b des Arretiermechanismus für die Box 1. Die mit den Schwenkhebeln 32a, 32b über die Bolzen 35a, 35b verbundenen Arretierelemente 31a, 31b sind in die Ausfräsungen 39a, 39b des Aufnahmerahmens 3 zurückgewichen, so daß die Box 1 samt des in ihr mittels der Verriegelungselemente 21a, 21b des Verriegelungsmechanismus verriegelten Boxenbodens 2 in den Aufnahmerahmen 3 einsetzbar ist. Die Verriegelungsbolzen 41a, 41b der Drehscheibe 45 des Schleusentors 4 stehen in ihrer Aufnahmeposition, so daß sie beim Einsetzen der Box 1 in den Aufnahmerahmen 3 in die Eingriffsbohrungen 26a, 26b der Schwenkscheibe 25 des Boxenbodens 2 eintauchen können.

Nach dem Aufsetzen der Box wird der im Bügel 56 aufgenommene Motor 58 aktiviert, der über die Gewindespindel 54 und das in der Gabel 53 vorgesehene Gegengewinde die Kurvenscheibe 43 in Richtung des Pfeiles P in Bewegung versetzt. Durch diese Schwenkbewegung der Kurvenscheibe 43 werden die Führungsbolzen 50a, 50b entlang der zweiten Kurvenbereiche 51a", 51b" der Schaltkurven 51a, 51b in Richtung der ersten Kurvenbereiche 51a', 51b' bewegt, wodurch die weiteren Schubstangen 44a, 44b zurückgezogen werden. Die Federkraft der Schwenkfedern 37 drückt die Arretierelemente 31a, 31b durch die Schlitze 310 des Aufnahmerahmens 3 aus ihrer Aufnahmestellung in ihre Arretierstellung, so daß sie an den nach außen vorspringenden Schultern 12a, 12b der Box 1 angreifen und derart die Box 1 im Aufnahmerahmen arretieren.

Die Schwenkbewegung der Kurvenscheibe 43 wird über die Verriegelungsbolzen 41a, 41b der fest mit der Kurvenscheibe 43 verbundenen Drehscheibe 45 auf die Schwenkscheibe 25 übertragen. Dies bewirkt, daß die Schubstangen 24a, 24b zurückweichen, wodurch die Verriegelungselemente 21a, 21b des Boxenbodens 2 zurückgezogen werden und ins Innere des Gehäuses 22 des Boxenbodens 2 zurückweichen. Dadurch wird die Verriegelung des Boxenbodens 2 von der nun durch die Arretierelemente 31a, 31b fest im Aufnahmerahmen 3 gehaltenen Box 1 gelöst, wodurch der Boxenboden 2 freigegeben wird.

Mit Hilfe des Hubwerks 5 wird dann das Schleusentor 4 mitsamt des Boxenbodens 2 und der auf ihm aufgesetzten Substrat-Kassette in den Reinstraum der Anlage abgesenkt.

In der umgekehrten Richtung des Funktionsablauf wird die entgegengesetzt (entgegen der Richtung des Pfeiles P) verlaufende Schwenkbewegung der Kurvenscheibe 43 durch die Verriegelungsbolzen 41a, 41b zuerst in eine Schwenkbewegung der Drehscheibe 25 umgesetzt, wodurch die Schubstangen 24a, 24b die Verriegelungselemente 21a, 21b nach außen in Richtung auf den Verriegelungsschlitz 11a, 11b der Box 1 hin bewegen, bis diese schließlich in die Verriegelungsschlitze 11a, 11b eintreten und - wie bereits oben beschrieben - den Boxenboden 2 hermetisch abdichtend in der Box 1 verriegeln. Durch eine weitere Schwenkbewegung der Kurvenscheibe 43 treten die weiteren Schubstangen 44a, 44b aus dem Gehäuse des Schleusentors 4 aus, beaufschlagen die Schwenkhebel 32a, 32b, wodurch entgegen der Verstellkraft der Schwenkfedern 37 die Arretierelemente 31a, 31b durch die Schlitze 310a, 310b des Aufnahmerahmens 3 in dessen Ausfräsungen 39a, 39b zurücktreten. Die Box 1 samt des mit ihr verriegelten Boxenbodens 2 ist nun nicht mehr im Aufnahmerahmen 3 arretiert. Sie kann deshalb leicht aus dem den Aufnahmerahmen 3 und das Schleusentor 4 gebildeten Schleusenbereich entnommen werden.

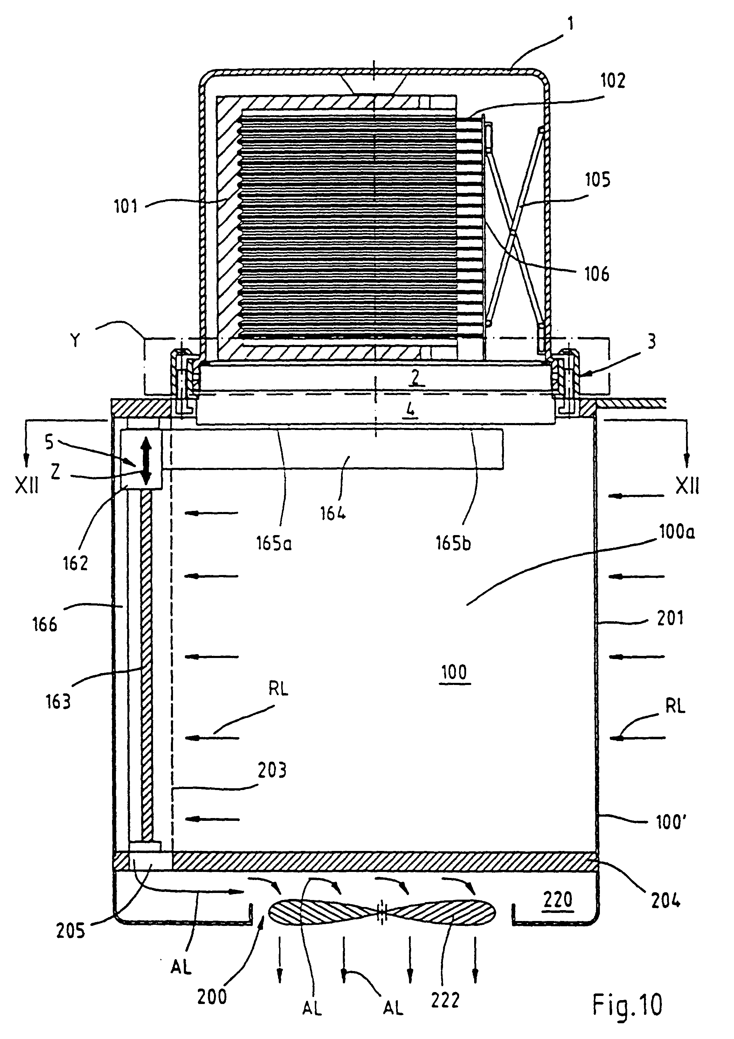

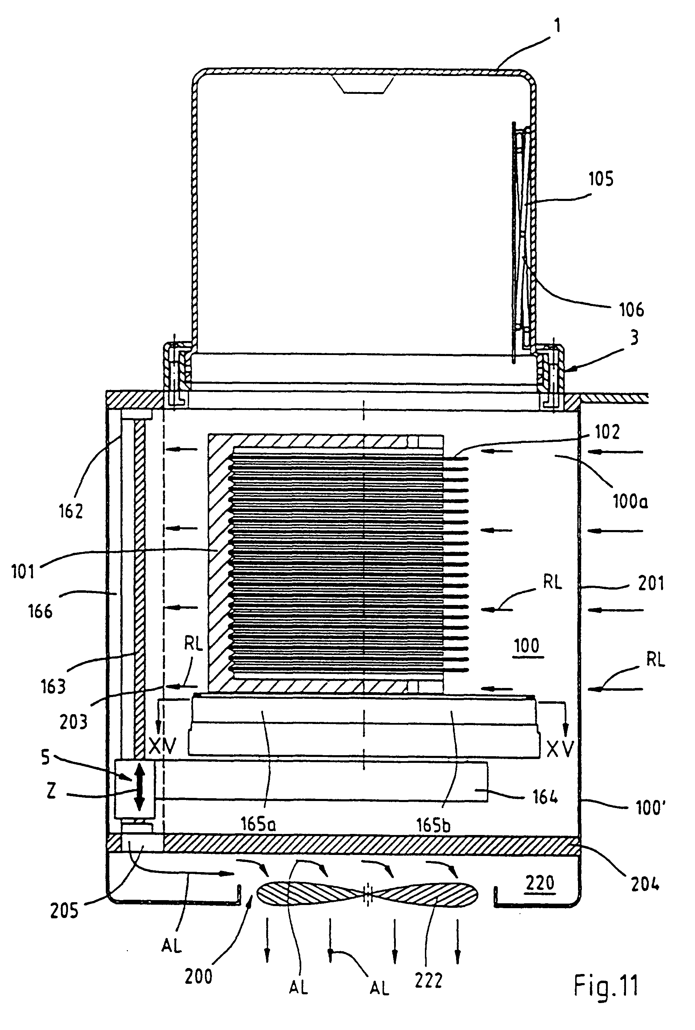

Das in den Fig. 10 und 11 dargestellte zweite Ausführungsbeispiel stimmt weitgehend mit dem vorstehend beschriebenen ersten Ausführungsbeispiel überein, so daß für gleiche Teile gleiche Bezugszeichen verwendet werden können. Im Sinne einer kurzen und prägnanten Beschreibung des zweiten Ausführungsbeispiels werden deshalb auch Teile und Elemente, die schon beim ersten Ausführungsbeispiel eingehend beschrieben wurden, im folgenden nicht mehr erneut erläutert.

Der auf den ersten Blick ins Auge fallende Unterschied zwischen der Fig. 1 und den Fig. 10 und 11 besteht darin, daß der in Fig. 1 nicht dargestellte und bei der Erläuterung des ersten Ausführungsbeispiels nur mit Worten beschriebene, unterhalb des Schleusentors 4 gelegene Reinstraum 100 nunmehr in diesen Figuren explizit dargestellt ist. Außerdem ist in Fig. 10 und 11 eine Kassette 101 mit Substraten 2 dargestellt, wobei in Fig. 10 die Kassette 101 in ihrer Aufnahmestellung und in Fig. 11 in ihrer in den Reinstraum 100 abgesenkten Position dargestellt ist.

Ein Unterschied zwischen dem ersten und dem zweiten Ausführungsbeispiel eines Systems zum Einschleusen von Substraten in Reinsträume besteht in einem seitlich an der Box 1 befestigten Scherengitter 105, welches über eine Andrückleiste 106 die Substrate 102 in der Kassette 101 fixiert. Dies geschieht dadurch, daß die Andrückleiste 106 des Scherengitters 105 im Verschlußzustand des Systems durch den Boxenboden 2 nach oben gedrückt wird. Dabei öffnet sich das Scherengitter 105 und schiebt die Andrückleiste 106 gegen die Substrate 102 und bewirkt damit deren Fixierung in der Kassette 101. Bei abgesenkten Boxenboden 2 legt sich dann das Scherengitter 105 mit der Andrückleiste 106 durch sein Eigengewicht an die Wand 1' der Box 1 an und gibt die Kassette 101 frei, so daß diese einfach in den Reinstraum 100 eingefahren werden kann (Fig. 11).

Durch das Scherengitter 105 und die Andrückleiste 106 wird eine Substrat-Fixiereinrichtung der Box 1 ausgebildet, welche in vorteilhafter Art und Weise eine lagefixierte Arretierung der Substrate 102 in ihrer Kassette 101 gewährleistet. Die Box 1 kann somit mit der in ihr aufgenommenen, mit Substraten 102 befüllten Kassette aus dem Aufnahmerahmen 3 entnommen und dann transportiert werden, ohne daß befürchtet werden muß, daß infolge von beim Entnahme- oder Transportvorgang auftretenden Vibrationen oder Erschütterungen die Substrate 102 aus der Kassette 101 fallen. Somit ist eine einfache Handhabung der Box 1 bei ihrer Entnahme aus dem Aufnahmerahmen 3 oder beim Transport gewährleistet, da auch eine nicht-horizontale Entnahme- oder Transportlage der Box 1 nicht zu einer Beschädigung der Substrate 102 führen kann.

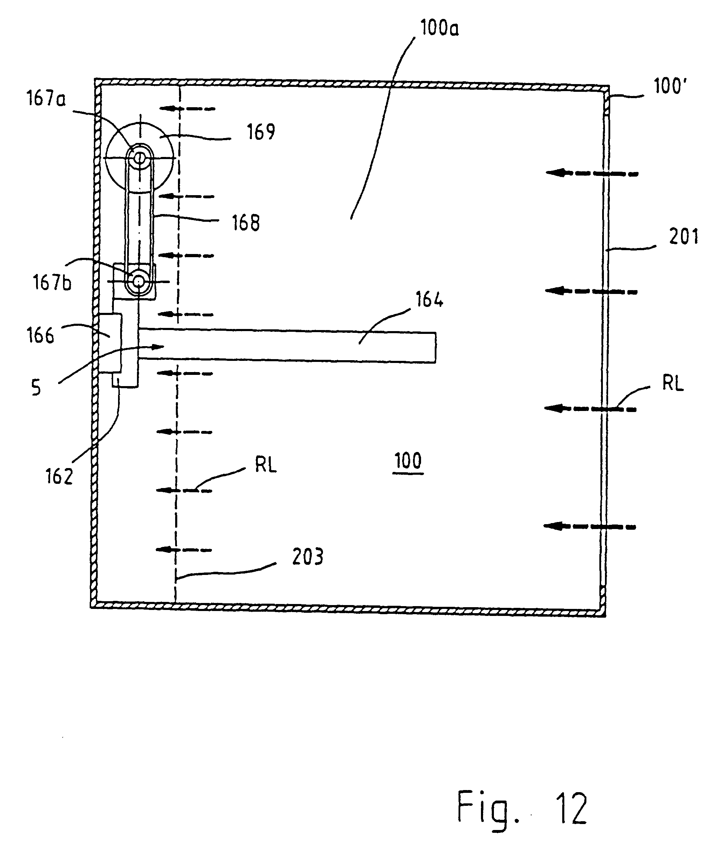

Das in den Reinstraum 100 integrierte Hubwerk 5 (siehe auch Fig. 12) weist eine elektromotorisch angetriebene Gewindespindel 163 auf, durch die ein Schlitten 162 entlang einer Führungsschiene 166 auf und ab bewegbar ist. Wie am besten aus Fig. 12 ersichtlich ist, erfolgt der Antrieb der Gewindespindel 163 durch einen Antriebsmotor 169, der über einen Riemen 168 und über Riemenscheiben 167a, 167b die in Richtung des Pfeils Z verlaufende Hubbewegung des Schlittens 162 bewerkstelligt. Ein am Schlitten 162 befestigter Tragarm 164 trägt über Nivellierbolzen 165a, 165b das Schleusentor 4.

Wichtig ist nun, daß in den Reinstraum 100 eine Lüftungseinrichtung 200 integriert ist. Hierzu weist eine Seitenwand 100' des Reinstraumes 100 eine Öffnung 201 auf, durch die Reinstluft in den Reinstraum 100 zuführbar ist. In den Fig. 10 bis 12 ist die in den Reinstraum 100 einströmende Reinstluft durch die Pfeile RL gekennzeichnet. Die zugeführte Reinstluft RL durchströmt den Reinstraum 100 und durchsetzt ein die Mechanik und den Antrieb des in den Reinstraum 100 integrierten Hubwerks abkapselndes Lochblech 203 und wird über eine Öffnung 205 des Gehäusebodens 204 des Reinstraums 100 in ein Lüftergehäuse 220 des Systems geleitet, in der eine Lüftereinheit 222 angeordnet ist.

Durch diese Zuführung von Reinstluft RL in den Reinstraum 100 wird in vorteilhafter Art und Weise den lufttechnischen Belangen eines derartigen Systems zum Einschleusen von Substraten in Reinsträume Rechnung getragen: Die vorzugsweise parallel zu den Substraten 102 einströmende Reinstluft RL bewirkt in vorteilhafter Art und Weise eine Spülung der in der Kassette 101 aufgenommenen Substrate 102 und verhindert, daß mit evtl. im Reinstraum 100 vorhandenen Schwebstoffen kontaminierte Luft zu den in der Kassette 101 aufgenommenen Substraten 102 gelangen kann. Die zugeführte Reinstluft RL bildet also eine Verdrängungsströmung aus, welche Schwebstoffe von den Substraten 102 fernhält. Das Lochblech 203 des Reinstraumes 100 bewirkt dabei eine gleichmäßige Ansaugung - also eine Verstetigung des Reinstluftstroms - der Reinstluft RL durch die Öffnungen 201 des Reinstraumes 100 und garantiert außerdem eine gleichmäßige Abführung der Reinstluft RL über die Öffnung 205 des Bodens 204 des Reinstraumes 100 in das Lüftergehäuse 220.

Von Vorteil hierbei ist, daß die Lüftereinheit 222 regelbar ausgebildet ist, so daß die durch die Reinstluft RL ausgebildete und eine Spülung der Substrate 102 bewirkende Verdrängungsströmung in ihrer Geschwindigkeit den jeweils äußeren Bedingungen - im wesentlichen dem Druckgefälle zwischen einströmender und ausströmender Luft - angepaßt werden kann. Hierdurch ist gewährleistet, daß die Lüfungseinrichtung 200 des beschriebenen Systems individuellen Vorgaben der Betreiber angepaßt werden kann.

Das im Reinstraum 100 vorgesehene Lochblech 203 bewirkt - außer für den gleichmäßigen Luftstrom der Reinstluft RL im Reinstraum 100 zu sorgen - desweiteren, daß an reibungsbehafteten Elementen des Hubwerks 5 entstehende Abriebpartikel nicht unmittelbar in den die mit Substraten 102 befüllte Kassette 101 aufnehmenden Teil 100a des Reinstraums 100 gelangen können. Eine derartige Gefahr einer Kontamination des Reinstraum-Teils 100a durch Abriebpartikel wird außerdem durch die beschriebene Luftführung der Reinstluft RL eliminiert: Denn diese flutet außer den die Substrate 102 aufnehmenden Teil 100a des Reinstraums 100 auch noch das Hubwerk 5, so daß die Abriebpartikel - wie sie bspw. bei der Bewegung des Schlittens 162 entlang der Führungsschiene 166 entstehen - sofort durch die Öffnung 205 des Gehäusebodens 204 des Reinstraums 100 in das Lüftergehäuse 220 abgeführt werden. Die symbolisch durch die Pfeile AL dargestellte Abluft des Reinstraums 100 wird also von der Lüftereinheit 222 über das Lüftergehäuse 220 abgeführt.

Es ist selbstverständlich ohne weiteres möglich, die Lüftungseinrichtung 200 des Reinstraums 100 des zweiten Ausführungsbeispiels auch beim System zum Einschleusen von Substraten gemäß dem ersten Ausführungsbeispiel einzusetzen.

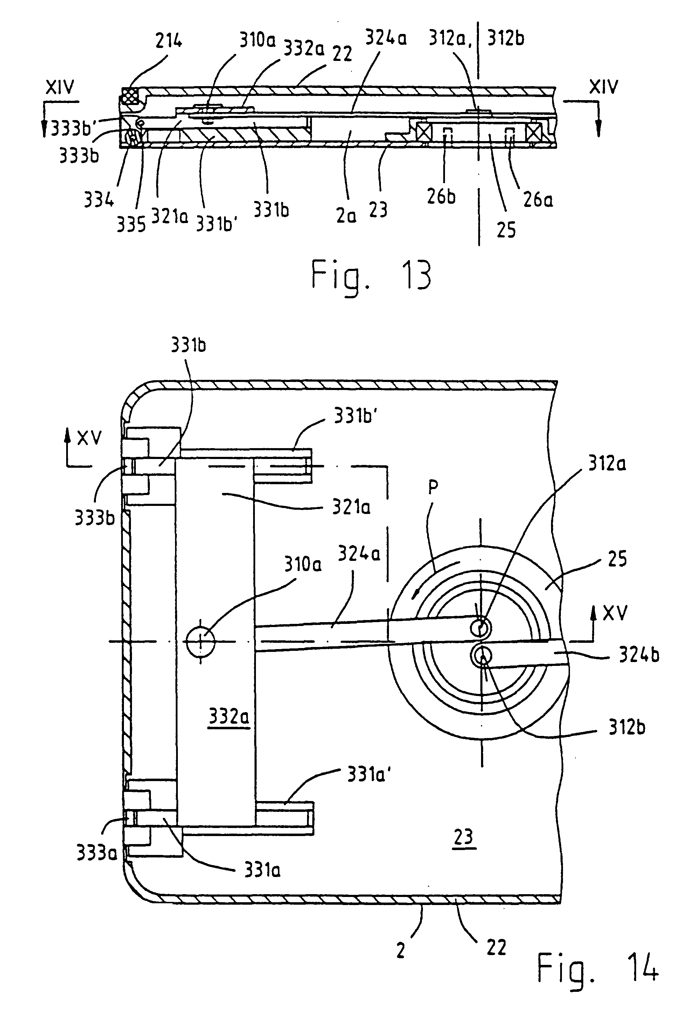

Die den Fig. 3 und 4 des ersten Ausführungsbeispiels entsprechenden Fig. 13 und 14 sowie die Fig. 15 zeigen eine zweite Ausführungsform des im Gehäuse 22 des Boxenbodens 2 angeordneten Verriegelungsmechanismus zur Fixierung des Boxenbodens 2 in der Box 1. An der Oberseite der Schwenkscheibe 25 ist - wie am besten aus Fig. 14 ersichtlich ist - über je ein Gelenk 312a, 312b je ein Ende einer Schubstange 324a, 324b angelenkt, deren anderes Ende über je ein weiteres Gelenk 310a, 310b mit einem Verriegelungselement 321a, 321b verbunden ist. Jedes Verriegelungselement 321a bzw. 321b weist zwei Schieber 331a, 331b auf, die in je einem Führungselement 331a', 331b' parallel zur Unterseite 23 des Boxenbodens 2 verschiebbar geführt und über ein Joch 332a, 332b gekoppelt sind. Mit den boxaußenseitigen Enden der Schieber 331a, 331b ist je ein in einem Drehpunkt 334 drehbar gelagerter Riegel 333a, 333b über ein weiteres Gelenk 335 verbunden ist.

Wird die Schwenkscheibe 25 in Richtung des Pfeiles P geschwenkt, so bewegt die Schubstange 324a, 324b ihr zugeordnetes Verriegelungselement 321a, 321b nach außen, wodurch der schnabelförmig ausgebildete Riegel 333a, 333b zu einer Drehbewegung um seinen Drehpunkt 334 gezwungen wird. Die schnabelförmigen Enden 333a', 333b' der Riegel 333a, 333b treten hierbei - wie am besten aus Fig. 15 ersichtlich ist - aus dem Gehäuse 22 des Boxenbodens 2 hervor und tauchen in die Verriegelungsschlitze 11a, 11b der Box 1 ein, die in dem unteren, an den Seitenflächen 2' des Boxenbodens 2 anliegenden Bereich 10 der Box 1 angeordnet sind. Durch diese Maßnahme wird wiederum eine sichere Verriegelung des Boxenbodens 2 in der Box 1 erreicht.

Bei der Schwenkbewegung der Schwenkscheibe 25 ist wiederum vorteilhafterweise vorgesehen, daß die Schubstangen 324a, 324b über den Totpunkt der Gelenke 312a, 312b gefahren werden. Die als Kniehebel ausgebildeten Schubstangen 324a, 324b schnappen am Ende ihrer Bewegung über ihren Totpunkt und verriegelt sich daher in vorteilhafter Art und Weise gegen selbsttätiges Öffnen. Infolge dieses bei der Verriegelungsbewegung der Riegel 333a, 333b auftretenden Kniehebeleffekts der Schubstangen 324a, 324b wird wiederum eine besonders hohe Krafteinwirkung auf die Dichtung 214 des Boxenbodens 2 erreicht, wodurch diese besonders fest gegen die Box 1 gedrückt wird. Die durch diese Kniehebeleffekt erzeugte äußerst hohe Verriegelungskraft zwischen Box 1 und Boxenboden 2 bewirkt eine einwandfreie Abdichtung. Die in dem von der Box 1 und dem in ihr verriegelten Boxenboden 2 hermetisch abgeschlossenen Raum aufgenommene Kassette 101 mit den darin befindlichen Substraten 102 kann daher gefahrlos durch eine kontaminierte Umgebung transportiert werden.

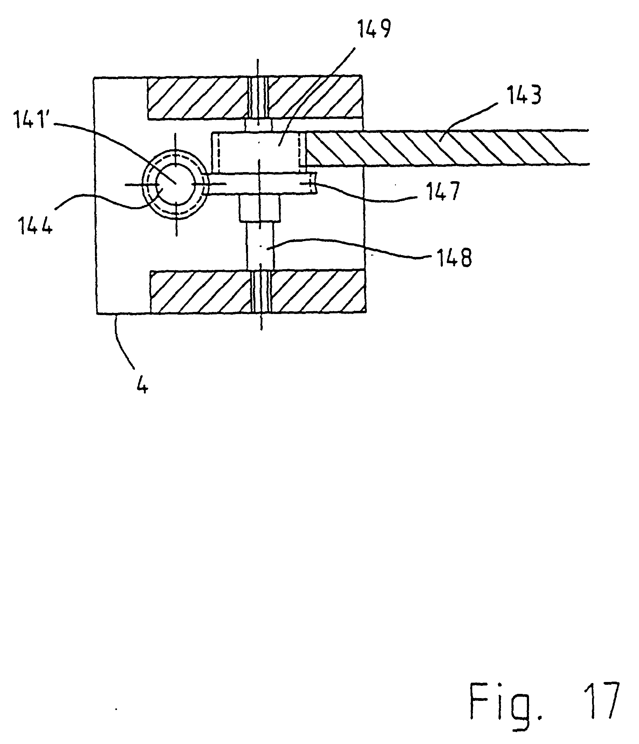

Das zweite Ausführungsbeispiel unterscheidet sich vom ersten Ausführungsbeispiel auch in der Art des Antriebs für die Drehscheibe 45 des die Box 1 samt eingesetzten Boxenbodens 2 im Aufnahmerahmen 3 arretierten Arretiermechanismus. Hierzu wird auf die Fig. 16 und 17 verwiesen, in denen beim die im zweiten Ausführungsbeispiel verwendete alternative Ausführungsform des in der Fig. 9 beschriebenen Arretiermechanismus des ersten Ausführungsbeispiels gezeigt ist: Eine der Kurvenscheibe 43 der Fig. 9 entsprechende Kurvenscheibe 143 wird nun mittels eines kombinierten Schnecken-Stirnrad-Getriebes angetrieben. Die mit der Drehscheibe 45 fest verbundene Kurvenscheibe 143 ist als Stirnrad ausgebildet, mit dem ein Ritzel 149 in Eingriff steht. Das Ritzel 149 und ein mit ihm fest verbundenes Schneckenrad 147 sind auf einer senkrecht zur Unterseite 2' des Boxenbodens 2 stehenden Achse 148 gelagert. Senkrecht dazu ist auf der Motorwelle 141' eines Getriebemotors 141 eine Schnecke 144 angeordnet. Der Getriebemotor 141 und seine Motorwelle sind hierbei auf zwei Wangen 142 und 143 gelagert.

Die beschriebene Anordnung dieser gemeinsamen Antriebsvorrichtung für den Arretier- und Verriegelungsmechanismus besitzt den Vorteil, daß der Getriebemotor 141 dadurch horizontal in die Schleusentür 4 eingebaut werden kann, wodurch in besonders einfacher Art und Weise eine kompakte Bauweise derselben erreichbar ist.

## Patentansprüche

1. SMIF-System zum Einschleussen von Substraten in einen Schleusenreinstraum (100), mit einer Box (1) zur Aufnahme einer die Substrate enthaltenden Kassette (101), mit einem im Schleusenreinstraum (100) integrierten Hubwerk (5) und mit einer Lüftungseinrichtung (200) für den Schleusenreinstraum (100), durch welche diesem ein die im Schleusenreinstraum (100) aufgenommenen Substrate (102) umströmender Reinstluftstrom (RL) zur Erzeugung einer Verdrängungsströmung zuführbar ist und durch die diese Reinstluft (RL) nach dem Durchströmen mindestens der im Schleusenreinstraum (100) aufgenommenen Substrate (102) aus dem Schleusenreinstraum (100) über ein abluftseitiges Gitterelement (203) zur Verstetigung des den Schleusenreinstraum (100) durchströmenden Reinstluftstroms (RL) abführbar ist, wobei die im Schleusenreinstraum (100) integrierte Lüftungseinrichtung (200) eine abluftseitig angeordnete Lüftereinheit (222) zur Abführung des den Schleusenreinstraum (100) durchströmenden Reinstluftstroms (RL) aufweist, **dadurch gekennzeichnet dass** das Hubwerk (5) in Strömungsrichtung des Reinstluftstroms (RL) nach den zu umströmenden Substraten (102) und das abluftseitige Gitterelement (203) des Schleusenreinstraums (100) in Strömungsrichtung des Reinstluftstroms (RL) vor dem Hubwerk (5) angeordnet ist.

## Claims

1. SMIF system for introducing substrates into a clean transfer chamber (100), with a box (1) for receiving a cassette (101) which contains the substrates, with a lifting mechanism (5) integrated in the clean transfer chamber (100) and with a ventilating device (200) for the clean transfer chamber (100) via which ventilating device (200) a clean flow of air (RL) which flows round the substrates (102) received in the clean transfer chamber (100) to produce a displacement flow can be conveyed to the clean transfer chamber and via which ventilating device (200) this clean air (RL) can be carried off after passing through at least the substrates (102) received in the clean transfer chamber (100), from the clean transfer chamber (100) via an exhaust-side grid element (203) to stabilise the clean air flow (RL) flowing through the clean transfer chamber (100), the ventilating device (200) integrated in the clean transfer chamber (100) comprising a fan unit (222) arranged at the exhaust-side for carrying off the clean air flow (RL) flowing through the clean transfer chamber (100), **characterised in that** the lifting mechanism (5) is arranged downstream of the substrates (102) around which air is to flow in the flow direction of the clean air flow (RL) and the exhaust-side grid element (203) of the clean transfer chamber (100) is arranged upstream of the lifting mechanism (5) in the flow direction of the clean air flow (RL).

## Revendications

1. Système SMIF pour introduire des substrats dans une pièce de transfert purifiée (100), avec un boîtier (1) destiné à recevoir une cassette (101) contenant les substrats, avec un dispositif de levage (5) intégré à la pièce de transfert purifiée (100) et avec un dispositif de ventilation (200) de la pièce de transfert purifiée (100), permettant d'introduire dans ladite pièce un courant d'air extra-pur (RL) ventilant les substrats (102) admis dans la pièce de transfert purifiée (100) pour produire un courant de refoulement, et permettant, après la ventilation au minimum des substrats (102) admis dans la pièce de transfert purifiée (100), d'évacuer ledit courant d'air extra pur (RL) de la pièce de transfert purifiée (100) à travers un élément formant grille (203) agencé côté air de refoulement et destiné à uniformiser la circulation du courant d'air extra-pur (RL) traversant la pièce de transfert purifiée (100), le dispositif de ventilation (200) intégré à la pièce de transfert purifiée (100) présentant, côté air de refoulement, une unité de ventilation (222) pour l'évacuation du courant d'air extra-pur (RL) traversant la pièce de transfert purifiée (100), **caractérisé en ce que** le dispositif de levage (5) est agencé en aval des substrats (102) à ventiler, dans le sens d'écoulement du courant d'air extra-pur (RL), et **en ce que** l'élément formant grille (203) agencé côté air de refoulement de la pièce de transfert purifiée (100) est prévu en amont du dispositif de levage (5) dans le sens d'écoulement du courant d'air extra-pur (RL).
